# EUROPEAN PATENT APPLICATION

(11) **EP 1 197 993 A1**
(43) Date of publication of application: **17.04.2002**
(21) Application number: 00929881.1
(22) Date of filing: 26.05.2000
(51) Int. Cl.: H01L 21/205, H01L 21/3065, F16K 51/02

(54) **APPARATUS FOR MANUFACTURING SEMICONDUCTOR DEVICE**

(30) Priority: 27.05.1999 JP 14813499
(71) Applicant: Applied Materials, Inc., Santa Clara, California 95054 (US)
(72) Inventor: SAITO, Kazuyoshi, Applied Materials Japan, Inc., Narita-shi, Chiba 286-8516 (JP); TAKAGI, Youji, Applied Materials Japan, Inc., Narita-shi, Chiba 286-8516 (JP)
(74) Representative: Cross, Rupert Edward Blount
(86) International application number: JP0003409
(87) International publication number: WO0074124

(57) **Abstract**

Epitaxial growth device (1) comprises wafer guide member (8) having passage (7) that communicates with wafer introduction port (5) of processing chamber (2) and opening/closure mechanism (9) that opens/closes passage (7). Opening/closure mechanism (9) comprises door (10) having door body (12) in which is formed annular groove (13) in which O-ring (14) is accommodated, and cylinder (11) that drives door (10). Also, chamfered section (15) is provided from outside peripheral section (13f) to the entire outside portion of annular groove (13) on aperture face (12a) of door body (12). In this way, when door (10) is closed, the peripheral section of door body (12) can be satisfactorily prevented from contacting wafer guide member (8).

## Description

### Technical Field

The present invention relates to a semiconductor manufacturing device such as an epitaxial growth device.

### Background Art

As examples of conventional semiconductor manufacturing devices, there may be mentioned epitaxial growth devices etc in which a feed chamber having a wafer feed path is linked to a processing chamber having a wafer introduction port for introduction of a semiconductor wafer constituting an article to be processed. In this feed chamber, there is provided a wafer guide member (a guide section for the article to be processed) having a passage linked with the wafer introduction port. Also, this prior art device comprises an opening/closure mechanism that opens/closes the passage of this wafer guide member.

The opening/closure mechanism comprises for example a door and a cylinder provided with a piston rod capable of extension/retraction, linked to this door. The door comprises a door body performed with an annular groove that opens in the face on the side facing the aperture of the wafer guide member. Also, an annular sealing member constituted by an O-ring is accommodated in the annular groove.

With such a prior art device, the passage is blocked by closing the door by extending the piston rod of the cylinder to move the door towards the face of the aperture of the wafer guide member until the O-ring contacts the aperture face of the wafer guide member.

### Disclosure of the Invention

As a result of detailed investigations of prior art devices as described above, the present inventors discovered the following problems thereof. Specifically, if the door body is tilted with respect of the aperture face of the wafer guide member, it is possible, when the door is closed, for the outside portion from the aperture of the annular groove in the door body to come into contact with the wafer guide member.

In particular, if the cord diameter of the O-ring mounted in the door body is small, the space (clearance) between the door body and the wafer guide member when the door is closed is correspondingly reduced, making it more likely that the door body will come into contact with the wafer guide member. When this happens, if the door body and the wafer guide member are both made of metal, there is a risk that metallic dust produced by contact of these two may flow into the processing chamber causing metallic contamination of the wafer.

In view of the above, an object of the present invention is to provide a semiconductor manufacturing device wherein contact of the door body and guide section of the article to be processed can be satisfactorily prevented when the door that performs opening/closure of the passage for introduction of the article to be processed into the chamber is opened/closed.

In order to achieve the above object, a semiconductor manufacturing device according to the present invention comprises a processing chamber, a guide section for an article to be processed having a passage for introduction of the article to be processed into this processing chamber and an opening/closure mechanism having a door whereby this passage is opened/closed wherein this door comprises: a door body having an annular groove opening in a face facing the open end of the passage and formed with a chamfered section on the outside of an outer peripheral section where the aperture of this annular groove is formed; and a sealing member that forms an annular shape and is accommodated in the annular groove.

In other words, a semiconductor manufacturing device according to the present invention comprises a processing chamber, a guide section for an article to be processed having a passage for introduction of the article to be processed into this processing chamber and an opening/closure mechanism having a door whereby this passage is opened/closed wherein this door comprises: a door body having an annular groove opening in a face on the side facing the aperture of the passage and an annular sealing member accommodated in the annular groove, formed with a chamfered section in a portion on the outside of an outer peripheral section where the aperture of this annular groove is formed in the door body.

With a semiconductor manufacturing device having such a construction, since a chamfered section is formed in a portion on the outside from the outside peripheral section forming the aperture of the annular groove provided in the door body, even if the door body is somewhat tilted with respect to the aperture face of the guide section for the article to be processed when the door is opened/closed, there is scarcely any possibility of the portion outside from the aperture of the annular groove in the door body coming into contact with the guide section for the article to be processed.

Preferably also the annular groove is formed from the bottom face, inside side face and outside side face, the inside side face has a region extending towards the inside of the door body and with slantwise respect to the side face of this door body from the inside peripheral section formed with the aperture of the annular groove and the outside side face comprises a first region extending from the outside peripheral section where the annular groove aperture is formed towards the outside of the door body and slantwise with respect to the side face of this door body and a second region extending substantially parallel with the side face of the door body from this first region.

That is, in a semiconductor manufacturing device according to the present invention, preferably, the annular groove is formed at the bottom face, inside side face and outside side face, the inside side face has a region extending slantwise towards the inside of the door body and with respect to the side face of this door body from the inside peripheral section formed with the aperture of the annular groove and the outside side face comprises a first region extending from the outside peripheral section where the annular groove aperture is formed towards the outside of the door body and slantwise with respect to the side face of this door body and a second region extending substantially parallel with the side face of the door body from this first region.

In this way, even when the external dimensions of the door body are made small with a view to miniaturizing the opening/closure mechanism, the annular sealing member can be prevented from coming out of the annular groove. Also, an annular groove can be formed of comparatively large dimensions having a desired thickness between this and the side face of the door body. A sealing member of comparatively large (thick) cord diameter can therefore be employed. In this way, a large clearance can be achieved between the door body when the door is closed and the wafer guide member constituting the guide section for the article to be processed. As a result, contact between the door body and the guide section for the article to be processed during opening/closure of the door can be more effectively prevented.

### Brief Description of the Drawings

Figure 1 is a diagrammatic cross-sectional view illustrating the construction of a preferred embodiment of a semiconductor manufacturing device according to the present invention, being a view illustrating diagrammatically an epitaxial growth device;
Figure 2 is an enlarged cross-sectional view illustrating a detail of a preferred embodiment of a semiconductor manufacturing device according to the present invention, being a view illustrating the wafer guide member and opening/closure mechanism in Figure 1;
Figure 3 is a perspective view illustrating another detail of a preferred embodiment of a semiconductor manufacturing device according to the present invention, being a view illustrating the door in Figure 2;
Figure 4 is a cross-sectional view illustrating yet another detail in a preferred embodiment of a semiconductor manufacturing device according to the present invention, being a view illustrating an annular groove formed in the door body in Figure 2; and
Figure 5A is a view illustrating the condition in which the door is closed by drive of a cylinder shown in Figure 2 and Figure 5B is a view illustrating the condition in which the door is opened by drive of this cylinder.

### Best Modes for Carrying Out the Invention

A preferred mode for carrying out the present invention is described in detail below with reference to the appended drawings. In the description of the drawings, duplicated description is avoided by appending the same reference symbols to identical elements. Also, regarding the up/down and left/right etc positional relationships, unless otherwise specified, these will be based on the positional relationships of up/down and left/right etc of the drawings.

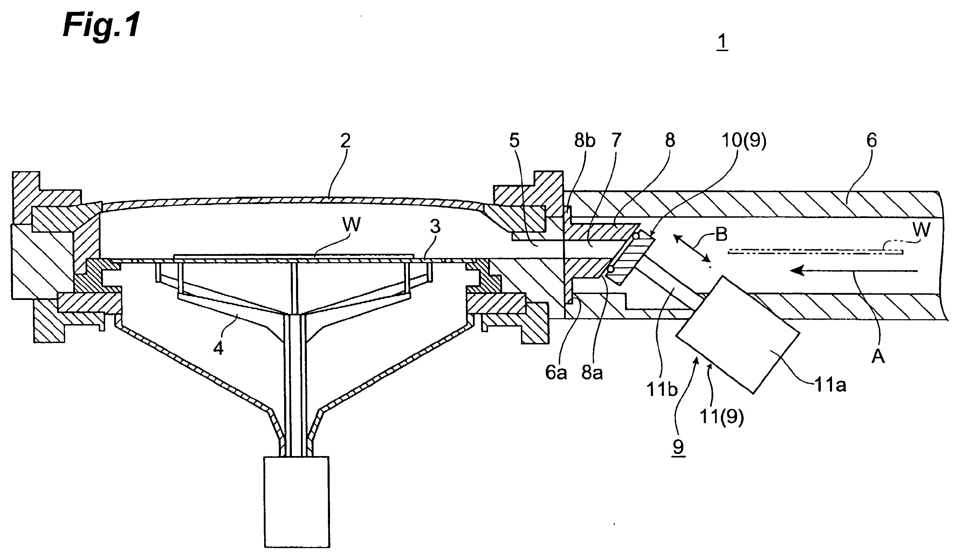

Figure 1 is a diagrammatic cross-sectional view illustrating the construction of a preferred embodiment of a semiconductor manufacturing device according to the present invention. The semiconductor manufacturing device constituted by epitaxial growth device 1 is a single wafer type device in which deposition treatment of an article to be treated consisting of one silicon wafer is performed at a time. This epitaxial growth device 1 comprises processing chamber 2 having disc-shaped susceptor 3 arranged therein, on the upper surface of which a wafer W is placed. Susceptor 3 is horizontally supported at three points from its back face by support shaft 4.

When, in a condition with wafer W placed on this susceptor 3, wafer W being heated by heating lamp (not shown) and reactive gas such as trichlorosilane (SiHCl₃) gas or dichlorosilane (SiH₂Cl₂) gas being supplied into processing chamber 2, this reactive gas flows in laminar flow condition along the surface of wafer W, a thin film is formed by epitaxial growth of single crystals of silicon on wafer W.

Also, at a prescribed location on the side wall of processing chamber 2, wafer introduction port 5 is formed for introducing wafer W from the side into processing chamber 2. The aperture width of this wafer introduction port 5 is made larger than the external diameter of wafer W. That is, wafer introduction port 5 is formed of rectangular shape in perpendicular cross section (vertical cross-section) extending in the horizontal direction (transverse direction i.e. direction orthogonal to the plane of the drawing in Figure 1) such that disc-shaped wafer W can pass therethrough.

Furthermore, sidewardly extending feed chamber 6 formed with wafer W feed path is connected to the side wall of processing chamber 2. Wafer W is fed in the direction of arrow A shown in the drawing through feed chamber 6 by a feed robot, not shown.

Within feed chamber 6, there is provided wafer guide member 8 (a guide section for the article to be processed) made of metal having passage 7 that communicates with wafer introduction port 5. This wafer guide member 8 projects sideways from the side wall of processing chamber 2. Also, aperture face 8a (an open end face on the opposite side to the side of processing chamber 2) at the tip of wafer guide member 8 is inclined with respect to the feed direction A of wafer W.

Furthermore, joining projection 8b is provided at the base end (the end on the side of processing chamber 2) of wafer guide member 8. Wafer guide member 8 is fixed to the side wall of processing chamber 2 in a condition with this joining projection 8b inserted into recess 6a formed at the end on the side of processing chamber 2 on feed chamber 6.

Also, passage 7 is formed in a rectangular shape extending in the horizontal direction (transverse direction i.e. direction orthogonal to the plane of the drawing in Figure 1) in perpendicular cross-section (vertical cross-section), corresponding to wafer introduction port 5, such that disc-shaped wafer W can pass therethrough. That is, wafer introduction port 5 and passage 7 have substantially identical cross-sectional shape.

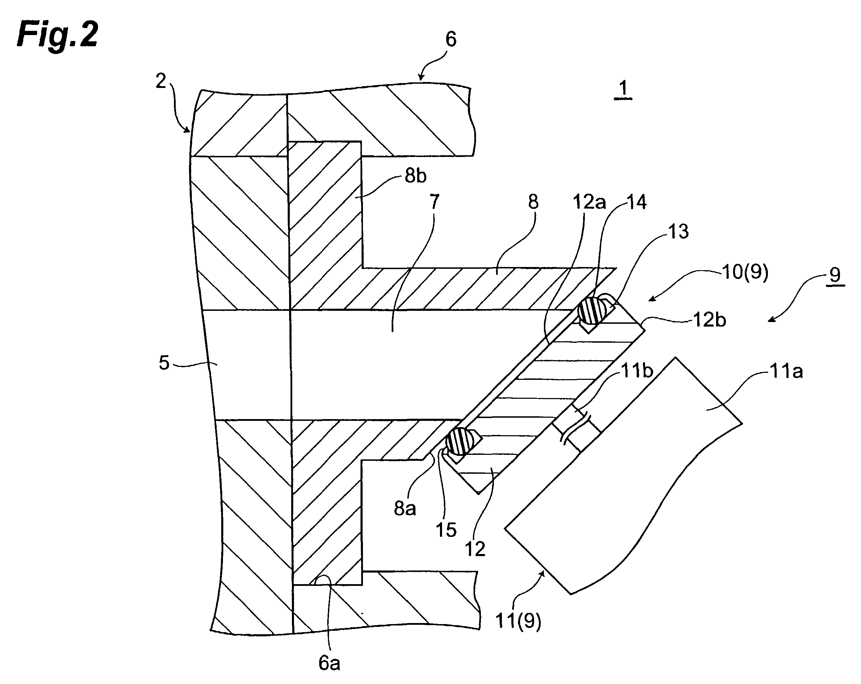

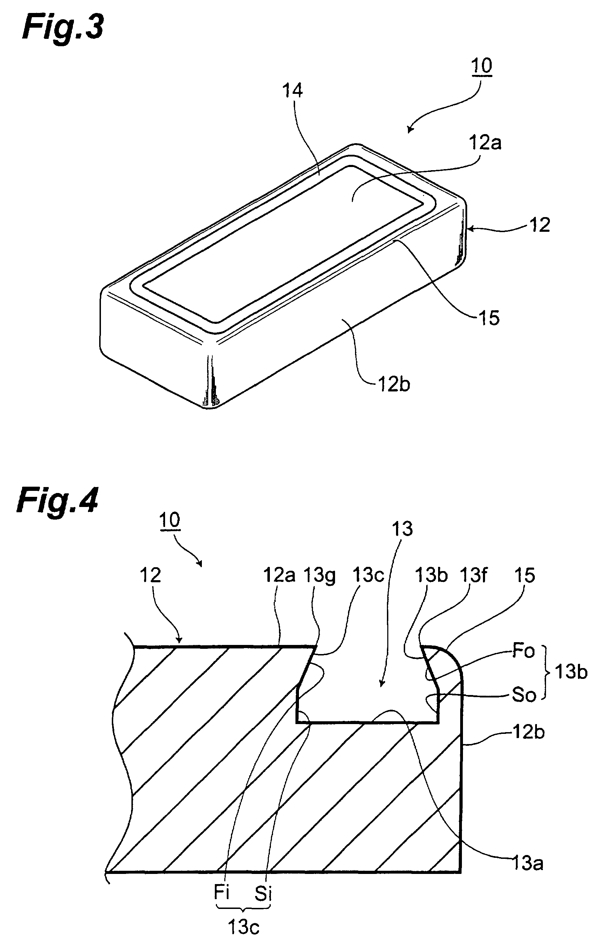

Passage 7 of this wafer guide member 8 is opened and closed by opening/closure mechanism 9. Opening/closure mechanism 9 comprises door 10 and cylinder 11 that drives this door 10. Figure 2 is an enlarged cross-sectional view (part omitted) illustrating wafer guide member 8 and opening/closure mechanism 9; Figure 3 is a perspective view illustrating door 10 of opening/closure mechanism 9.

In this Figure, door 10 has door body 12 made of metal of rectangular shape, its external dimensions being larger than the aperture section of wafer guide member 8 and smaller than the external dimensions of aperture face 8a. Also, in the vicinity of the periphery of door body 12, there is formed annular groove 13 opening in face 12a on the side opposite the open end of wafer guide member 8 i.e. aperture face 8a. Furthermore, O-ring 14 constituting an annular sealing member is accommodated in this annular groove 13.

Figure 4 is a cross-sectional view illustrating annular groove 13 formed in door body 12 in Figure 2. As shown in Figure 4, annular groove 13 is formed (defined) by bottom face 13a, outside side face 13b and inside side face 13c. Outside side face 13b comprises first region Fo extending continuously from outside peripheral section 13f forming the aperture of annular groove 13 towards bottom face 13a and second region So.

First region Fo in this outside side face 13b extends from outside peripheral section 13f towards the outside of door body 12 (towards side face 12b of door body 12) and extends slantwise with respect to this side face 12b. Also, second region So in outside side face 13b extends substantially parallel with side face 12b from this first region Fo towards bottom face 13a.

Inside side face 13c comprises first region Fi and second region Si extending continuously from inside peripheral section 13g forming the aperture of annular groove 13 towards bottom face 13a.

First region Fi in this inside side face 13c extends from inside peripheral section 13g towards the inside of door body 12 (towards the middle of door body 12) and slantwise with the respect to side face 12b of door body 12. Also, second region Si in outside side face 13b extends from this first region Fi in substantially parallel fashion to side face 12b from bottom face 13a.

In this way, the construction is such that respective first regions Fo and Fi are provided in outside side face 13b and inside side face 13c and annular groove 13 widens from this aperture (aperture face) towards bottom face 13a. Consequently, it is made difficult for O-ring 14 accommodated in annular groove 13 to become detached from annular groove 13.

Also, the depth of annular groove 13 is made to be of a dimension (see Figure 2) such that a part of O-ring 14 extends (protrudes) from annular groove 13 when O-ring 14 is accommodated in this annular groove 13. In this way, detachment of O-ring 14 from annular groove 13 is even more effectively prevented.

Also, by forming outside side face 13b and inside side face 13c in this way by respectively first region Fo and second region So, and first region Fi and second region Si, it is made difficult for O-ring 14 to become detached even if the external dimensions of door body 12 are small; thus, annular groove 13 of comparatively large dimensions can be formed whereby a sufficient thickness (width) can be achieved such that there is no possibility of impairing the strength of the peripheral section of door body 12. Reduction in size of opening/closure mechanism 9 can thereby be achieved.

Furthermore, if this done, O-ring 14 of comparatively large (thick) cord diameter can be employed. If such O-ring 14 of large cord diameter is mounted in door body 12, the portion extending from aperture face 12a of door body 12 in O-ring 14 becomes long. In this way, in a condition in which passage 7 of wafer guide member 8 is blocked by closing door 10 as shown in Figure 2, the clearance of aperture face 12a of door body 12 and aperture face 8a of wafer guide member 8 can be increased.

Also furthermore, when door 10 is closed, O-ring 14 accommodated in annular groove 13 is crushed by adhering to (contacting) aperture face 8a of wafer guide member 8. Also, outside side face 13b and inside side face 13c described above are formed such that the crushed portion in O-ring 14 cannot contact second regions So, Si.

Also, instead of providing second region Si in inside side face 13c, it would be possible to extend first region Fi as far as bottom face 13a. That is, first region Fi of inside side face 13c may be made of a shape extending towards the inside of door body 12 slantwise with respect to side face 12b of door body 12 from inside peripheral section 13g forming the aperture of annular groove 13 as far as bottom face 13a.

Furthermore, chamfered section 15 is formed on the entire outside portion at aperture face 12a of door body 12, from outside peripheral section 13f forming the aperture of annular groove 13. This chamfered section 15 is formed for example such that the chamfer lengths (cutaway lengths) of portion of aperture face 12a and portion of side face 12b are substantially equal.

Furthermore, a thickness such that the strength of the peripheral section of door body 12 cannot be impaired is guaranteed between outside side face 13b of annular groove 13 and chamfered section 15.

Returning to Figure 1 and Figure 2, cylinder 11 that operates door 10 comprises cylinder tube 11a mounted in feed chamber 6 and piston rod 11b connected with door body 12. For example an air cylinder may be employed as this cylinder 11.

Piston rod 11b is extensible in the direction of arrow B as shown in Figure 1 with respect to cylinder tube 11a, so as to displace door body 12 between aperture face 8a of wafer guide member 8 and cylinder tube 11a. Also, cylinder tube 11a is arranged in a tilted condition with respect to feed chamber 6 such that aperture face 12a of door body 12 faces aperture face 8a of wafer guide member 8.

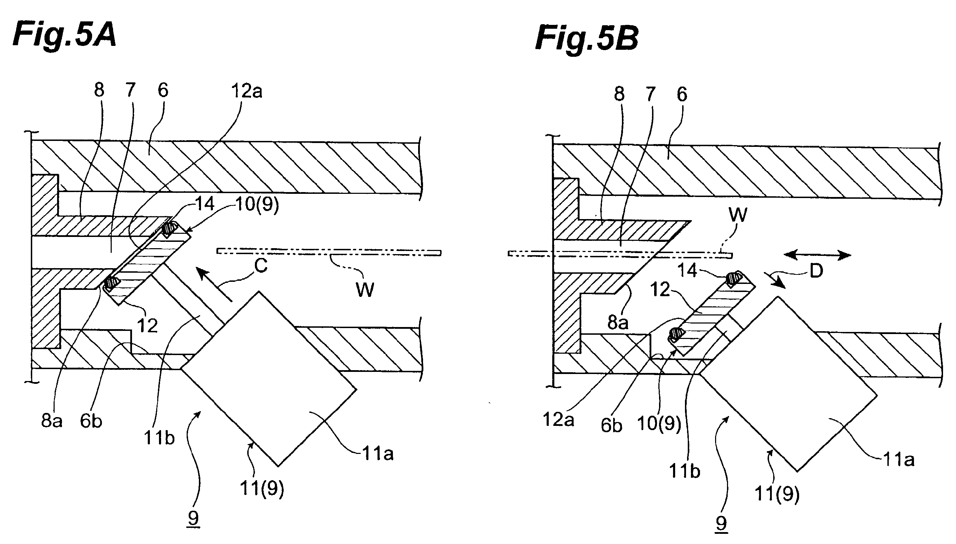

In such cylinder 11, as shown in Figure 5A, when passage 7 of wafer guide member 8 is blocked by closing door 10, piston rod 11b is extended in the direction of arrow C. Door 10 is then pushed onto aperture face 8b of wafer guide section 8 until O-ring 14 is in good contact with wafer guide section 8.

When wafer W is to be fed between processing chamber 2 and the outside by means of a feed robot, not shown, as shown in Figure 5B, when passage 7 of wafer guide member 8 is opened by opening door 10, piston rod 11b is retracted in the direction of arrow D. In this way, door 10 is pulled away from aperture face 8a of wafer guide member 8.

Recess 6b to accommodate door 10 when retracted is provided in a location at the bottom of feed chamber 6 facing aperture face 8a of wafer guide member 8. By means of this, door 10 can be retracted downwards into a position such that wafer W can be introduced into passage 7 of wafer guide member 8 when door 10 is opened. In this way, wafer W can be introduced into processing chamber 2 in a smooth fashion without any interference between door 10 and wafer W.

With epitaxial growth device 1 constructed in this way, owing to the fact that, in door body 12, chamfered section 15 is provided from outside peripheral section 13f forming the aperture of annular groove 13 on the whole of the outside portion and outside side face 13b and inside side face 13c of annular groove 13 are respectively formed by first region Fo and second region So, and first region Fi and second region Si, so that, even when the external dimensions of door body 12 are small, O-ring 14 of comparatively large cord diameter can be mounted, the following principle operational benefits are presented.

Specifically, even if aperture face 12a of door body 12 is somewhat inclined with respect to aperture face 8a of wafer guide member 8 when door 10 is closed, there is practically no possibility of the peripheral section of door body 12 contacting wafer guide member 8. In this way, the possibility of metallic dust generated by contact of door body 12 with wafer guide member 8 flowing into processing chamber 2 becomes extremely low, enabling metallic contamination of wafer W to be reduced or suppressed.

While a preferred embodiment of the present invention has been described above, the present invention is of course not restricted to this embodiment. For example, an outside side face and an inside side face are not restricted to outside side face 13b and inside side face 13c but could be for example of a shape extending so as to spread over the whole thereof, from the aperture (aperture edge) of annular groove 13 to a bottom face.

That is, while, in the above embodiment, outside side face 13b and inside side face 13c of annular groove 13 were formed by first regions Fo, Fi extending so as to spread from the aperture (aperture edge) of annular groove 13 and second regions So, Si extending substantially parallel with side face 12b from these first regions Fo, Fi, there is no particular restriction to this.

Also, the present invention can be suitably applied to semiconductor manufacturing devices other than epitaxial growth device 1, such as for example CVD devices or dry etching devices, in which an article to be processed is introduced into a processing chamber.

### Industrial Applicability

As described above, with the present invention, a door body can be prevented from coming into contact with the guide section of an article to be processed during opening/closure of the door. Consequently, inflow of metallic dust generated by contact of the door body with the guide section of the article to be processed into a processing chamber can be satisfactorily prevented or suppressed. In this way, metallic contamination of the article to be processed can be reduced.

## Claims

1. A semiconductor manufacturing device comprising a processing chamber, a guide section for an article to be processed having a passage for introduction of the article to be processed into said processing chamber and an opening/closure mechanism having a door for opening/closing said passage, wherein said door comprises:
a door body having an annular groove opening in a face facing the open end of said passage and formed with a chamfered section on the outside of an outer peripheral section where the aperture of said annular groove is formed; and
a sealing member that forms an annular shape and is accommodated in said annular groove.

2. The semiconductor manufacturing device according to claim 1, wherein said annular groove is formed from a bottom face, an inside side face and an outside side face;
said inside side face has a region extending towards the inside of said door body and slantwise with respect to a side face of said door body, from the inside peripheral section formed with the aperture of said annular groove; and
said outside side face comprises a first region extending from the outside peripheral section, where said annular groove aperture is formed, towards the outside of said door body and slantwise with respect to the inside face of said door body and a second region extending substantially parallel with the side face of said door body from said first region.
